# EUROPÄISCHE PATENTSCHRIFT

(11) **EP 2 834 855 B1**
(45) Veröffentlichungstag und Bekanntmachung des Hinweises auf die Patenterteilung: **21.08.2019**
(21) Anmeldenummer: 13706211.3
(22) Anmeldetag: 15.02.2013
(51) Int. Cl.: H01L 31/0749, H01L 27/142

(54) **VERFAHREN ZUR HERSTELLUNG VON DÜNNSCHICHTSOLARMODULEN SOWIE NACH DIESEM VERFAHREN ERHÄLTLICHE DÜNNSCHICHTSOLARMODULE**
METHOD FOR FABRICATING THIN FILM SOLAR MODULES AND THIN FILM SOLAR MODULE OBTAINABLE BY THIS METHOD
PROCÉDÉ DE FABRICATION DE MODULES SOLAIRES À COUCHE MINCE ET MODULE SOLAIRE À COUCHE MINCE OBTENU PAR CE PROCÉDÉ

(30) Priorität: 02.04.2012 DE 102012205378
(43) Veröffentlichungstag der Anmeldung: 11.02.2015
(73) Patentinhaber: Probst, Volker, 14089 Berlin (DE)
(72) Erfinder: Probst, Volker, 14089 Berlin (DE)
(74) Vertreter: Metten, Karl-Heinz
(86) Internationale Anmeldenummer: PCT/EP2013/053111
(87) Internationale Veröffentlichungsnummer: WO 2013/149751

(56) Entgegenhaltungen:
- WO-A2-2011/032717
- US-A- 5 296 674
- US-A- 5 626 688
- US-A1- 2003 213 974
- US-A1- 2008 251 120
- US-A1- 2008 308 148
- US-A1- 2010 300 525

## Beschreibung

Die vorliegende Erfindung betrifft ein Verfahren zur Herstellung von photovoltaischen Dünnschichtsolarmodulen sowie die nach diesem Verfahren erhältlichen Dünnschichtsolarmodule.

Photovoltaische Dünnschichtsolarmodule sind seit langem bekannt und auch im Handel erhältlich. Derartige Module basieren in der Regel auf der Verwendung einer sogenannten Chalkopyrit-Halbleiterabsorberschicht, beispielsweise einem Cu(In,Ga)(Se,S)-System, und stellen ein komplexes Mehrschichtsystem dar. Die Herstellung solcher Dünnschichtsolarmodule ist ein vielstufiger Prozess, bei dem aufgrund zahlreicher Wechselwirkungen jede Verfahrensstufe sorgsam auf nachfolgende Verfahrensstufen abgestimmt werden muss. Anlagentechnisch bedingt ist es vielfach nicht oder nur sehr schwer möglich, Dünnschichtsolarmodule großtechnisch zu fertigen, deren Modulformat eine Größe von 1,2 m x 0,5 m überschreitet. Auch kann bislang bei den in einzelnen Herstellstufen anzuwendenden Temperaturen und Reaktionsbedingungen eine Kontamination oder Interdiffusion von Komponenten, Dotierstoffen oder Verunreinigungen einzelner Schichten des Mehrschichtsystems nicht ausgeschlossen werden.

Es wäre daher wünschenswert, auf ein Verfahren zur Herstellung von photovoltaischen Dünnschichtsolarmodulen zurückgreifen zu können, das nicht mit den Nachteilen des Stands der Technik behaftet ist und das insbesondere mit weniger Prozessschritten auskommt und gleichwohl nicht Restriktionen, beispielsweise hinsichtlich Modulformaten, ausgesetzt ist, wie sie aus den Verfahren des Stands der Technik bekannt sind.

Eine verbesserte Herstellungsmethode wird in der US 5,626,688 offenbart. Dabei wird über einem Substrat eine Barriereschicht abgelagert, um eine Diffusion zu unterbinden. Anschließend erfolgt die Aufbringung der Rückelektrode. Sodann wird eine Halbleiterschicht aufgebracht, wobei Alkalimetalle dergestalt eindiffundiert werden, dass eine alkalireiche und eine alkaliarme Region entsteht.

In der US 2003/0213974 werden verschiedene Strukturierungsschritte offenbart, wobei die Schichtfolge ein Substrat, eine leitfähige Schicht und eine Halbleiterschicht mit n- und p-Dotierung vorsieht. Es werden dabei Trenngräben zwischen den Schichten mit isolierendem Material gefüllt. Ferner wird ein transluzentes Oxid verwendet, um nicht durchgehende Gräben aufzufüllen.

Aus US 2008/0251120 geht eine Dünnfilm-Solarzelle hervor, umfassend einen rückseitigen Verbundkontakt zwischen einem Substrat und einer Chalcopyrit-Halbleiterabsorberschicht, wobei der rückseitige Verbundkontakt eine leitfähige Schicht, eine aus ZrN gebildete Reflektorschicht und eine Kontaktschicht umfasst.

Demgemäß wurde ein Verfahren zur Herstellung von photovoltaischen Dünnschichtsolarmodulen gefunden, wie im Anspruch 1 angegeben.

Vorzugsweise ist das Substrat zumindest bereichsweise für elektromagnetische Strahlung der ersten Laserbehandlung durchlässig. Geeignete Substrate umfassen z.B. Glassubstrate wie Glasscheiben. Alternativ kann auch auf flexible und nicht-flexible Kunststoffschichten, beispielsweise Kunststofffolien, oder Edelstahlschichten bzw. -folien zurückgegriffen werden.

In einer geeigneten Ausgestaltung des erfindungsgemäßen Verfahrens ist vorgesehen, dass die Rückelektrode enthält oder im Wesentlichen gebildet ist aus Wolfram, Chrom, Tantal, Niob, Vanadium, Mangan, Titan, Zirkonium, Cobalt und/oder Molybdän, vorzugsweise Wolfram, Titan und/oder Molybdän, oder aus einer Legierung enthaltend Wolfram, Chrom, Tantal, Niob, Vanadium, Mangan, Titan, Zirkonium, Cobalt, Eisen, Nickel, Aluminium und/oder Molybdän. Die Rückelektrode im Sinne der vorliegenden Erfindung kann auch als Bulk-Rückelektrode und das System aus Bulk-Rückelektrode, Barriereschicht und Kontaktschicht als Mehrschicht-Rückelektrode bezeichnet werden. Dabei kann in einer bevorzugten Ausgestaltung vorgesehen sein, dass die Bulk-Rückelektrode und die Kontaktschicht Molybdän oder Wolfram oder eine Molybdän- oder Wolframlegierung, insbesondere Molybdän oder eine Molybdänlegierung, enthalten oder im Wesentlichen aus Molybdän oder Wolfram oder einer Molybdän- oder Wolframlegierung, insbesondere Molybdän oder einer Molybdänlegierung, gebildet sind.

Bei dem erfindungsgemäßen Verfahren ist die leitfähige Barriereschicht eine bidirektional wirkende Barriereschicht für aus der und/oder über die Rückelektrodenschicht migrierende, insbesondere diffundierende bzw. diffundierbare Komponenten, insbesondere Dotierstoffe, und für aus der und/oder über die Kontaktschicht, insbesondere aus der Halbleiterabsorberschicht, diffundierende bzw. diffundierbare Komponenten, insbesondere Dotierstoffe. Hierbei ist insbesondere vorgesehen, dass die Barriereschicht eine Barriere gegenüber Alkaliionen, insbesondere Natriumionen, Selen oder Selenverbindungen, Schwefel oder Schwefelverbindungen und/oder Metallen, insbesondere Eisen, Nickel und/oder Metallen der Halbleiterabsorberschicht, darstellt, beispielsweise gegenüber Cu, In, Ga, Fe, Ni, Al, Ti, Zr, Hf, V, Nb, Ta und/oder W. Vorzugsweise enthält die Barriereschicht oder ist im Wesentlichen gebildet aus mindestens einem Metallnitrid, mindestens einem Metallsiliziumnitrid, mindestens einem Metallcarbid und/oder mindestens einem Metallborid. Bevorzugt stellt das Metall der Metallnitride, Metallsiliziumnitride, Metallcarbide und/oder Metallboride Titan, Molybdän, Tantal, Zirkonium oder Wolfram dar. Besonders bevorzugt enthält die Barriereschicht oder ist im Wesentlichen gebildet aus TiN, TiSiN, MoN, TaSiN, MoSiN, TaN, WN, ZrN und/oder WSiN.

Die leitfähige Barriereschicht stellt als bidirektional wirkende Barriereschicht eine Barriere für aus der und/oder über die Rückelektrodenschicht migrierende, insbesondere diffundierende bzw. diffundierbare Komponente, insbesondere Dotierstoffe, und für aus der und/oder über die Kontaktschicht, insbesondere aus der Halbleiterabsorberschicht, diffundierende bzw. diffundierbare Komponente, insbesondere Dotierstoffe, dar. Bedingt durch den Umstand des Vorliegens einer Barriereschicht ist es z.B. möglich, den Reinheitsgrad des Bulk-Rückelektrodenmaterials signifikant zu reduzieren. Beispielsweise kann die Bulk-Rückelektrodenschicht verunreinigt sein mit mindestens einem Element ausgewählt aus der Gruppe bestehend aus Fe, Ni, Al, Cr, Ti, Zr, Hf, V, Nb, Ta, W und/oder Na und/oder mit Verbindungen der genannten Elemente, ohne dass der Wirkungsgrad der die erfindungsgemäße Rückelektrode aufweisenden Dünnschichtsolarzelle bzw. des - moduls nachhaltig beeinträchtigt wird.

Derartige Metallnitride sind bevorzugt als Barrierematerialien im Sinne der vorliegenden Erfindung, beispielsweise TiN, bei denen das Metall hinsichtlich Stickstoff stöchiometrisch oder überstöchiometrisch, also mit Stickstoff im Überschuss, abgeschieden wird.

Ein weiterer Vorteil des Einsatzes einer Barriereschicht mit der erfindungsgemäßen Mehrschicht-Rückelektroden manifestiert sich bei Verwendung in Dünnschichtsolarzellen und - modulen darin, dass die Dicke der Halbleiterabsorberschicht, beispielsweise der Chalkopyrit- oder Kesterit-Schicht, gegenüber herkömmlichen System merklich verringert werden kann. Denn durch die Barriereschicht, insbesondere wenn in Form von Metallnitriden, beispielsweise Titannitrid, oder enthaltend solche Metall- bzw. Titannitride vorliegend, wird das die Halbleiterabsorberschicht passierende Sonnenlicht sehr effektiv reflektiert, so dass sich im Wege des Doppeldurchtritts durch die Halbleiterabsorberschicht eine sehr gute Quantenausbeute erzielen lässt. Durch die Anwesenheit der genannten Barriereschicht in der erfindungsgemäßen Rückelektrode bzw. in Dünnschichtsolarzellen bzw. -modulen, enthaltend diese Rückelektrode kann die durchschnittliche Dicke der Halbleiterabsorberschicht auf z. B. Werte im Bereich von 0,4µm bis 1,5 µm, beispielsweise auf Werte im Bereich von 0,5 µm bis 1,2 µm, verringert werden.

Die Barriereschicht der erfindungsgemäßen Rückelektrode verfügt in einer besonders zweckmäßigen Ausgestaltung über Barriereeigenschaften, insbesondere bidirektionale Barriereeigenschaften, gegenüber Dotierstoffen, insbesondere gegenüber Dotierstoffen für die Halbleiterabsorberschicht und/oder aus der Halbleiterabsorberschicht, gegenüber Chalkogenen wie Selen und/oder Schwefel sowie Chalkogenverbindungen, gegenüber den metallischen Bestandteilen der Halbleiterabsorberschicht wie Cu, In, Ga, Sn und/oder Zn, gegenüber Verunreinigungen wie Eisen und/oder Nickel aus der Bulk-Rückelektrodenschicht und/oder gegenüber Komponenten und/oder Verunreinigungen aus dem Substrat. Die bidirektionalen Barriereeigenschaften gegenüber Dotierstoffen aus dem Substrat sollen zum einen eine Anreicherung an der Grenzfläche der Rückelektrode bzw. Kontaktschicht zur Halbleiterabsorberschicht mit Alkaliionen, z.B. ausdiffundierend aus einem Glassubstrat, verhindern. Solche Anreicherungen sind bekannt als Grund für Halbleiter-Schichtablösungen. Die leitfähige Barrierenschicht soll damit Haftungsprobleme vermeiden helfen. Andererseits soll die Barriereeigenschaft für Dotierstoffe, ausdiffundierbar bzw. ausdiffundierend aus dem Halbleiterabsorber, verhindern, dass Dotierstoff auf diese Weise an die Bulk-Rückelektrode verlorengeht und damit der Halbleiterabsorber an Dotierstoff verarmt, was den Wirkungsgrad der Solarzelle oder des Solarmoduls deutlich reduzieren würde. Denn es ist beispielsweise bekannt, dass Molybdän-Rückelektroden signifikante Mengen an Natrium-Dotierstoff aufnehmen können. Die bidirektionale leitfähige Barriereschicht soll somit die Voraussetzungen für eine gezielte Dosierung von Dotierstoff in die Halbleiterabsorberschicht ermöglichen, um reproduzierbar hohe Wirkungsgrade der Solarzellen und -Modulen erreichen zu können.

Die Barriereeigenschaft gegenüber Chalkogenen soll verhindern, dass diese an die Rückelektrode gelangen und dort Metallchalkogenidverbindungen ausbilden. Bekanntlich tragen diese Chalkogenidverbindungen, z.B. MoSe, zu einer erheblichen Volumenvergrößerung der oberflächennahen Schicht der Rückelektrode bei, was wiederum Unebenheiten in der Schichtenstruktur und verschlechterte Haftung mit sich bringt. Verunreinigungen des Bulk-Rückelektrodenmaterials wie Fe und Ni stellen sogenannte tiefe Störstellen für z.B. Chalkopyrit-Halbleiter (Halbleitergifte) dar und sind demzufolge über die Barriereschicht von der Halbleiterabsorberschicht fernzuhalten.

In einer zweckmäßigen Ausgestaltung weist die Barriereschicht üblicherweise eine durchschnittliche Dicke von mindestens 10 nm, insbesondere mindestens 30 nm und vorzugsweise von maximal 250 nm oder 150 nm, auf.

Die Kontaktschicht grenzt vorzugsweise auf der dem Substrat zugewandten Seite unmittelbar an die Barriereschicht und/oder an der der Frontelektrode zugewandten Seite unmittelbar an die Halbleiterabsorberschicht an. Geeigneter Weise enthält die Kontaktschicht mindestens ein Metallchalkogenid. Vorteilhafterweise wird das Metall des Metallchalkogenids ausgewählt aus der Gruppe bestehend aus Molybdän, Wolfram, Tantal, Cobalt, Zirkonium und/oder Niob und/oder dass das Chalkogen ausgewählt ist aus der Gruppe bestehend aus Selen und/oder Schwefel. Eine zweckmäßige Ausgestaltung des erfindungsgemäßen Verfahrens sieht hierbei vor, dass die Kontaktschicht enthält oder im Wesentlichen gebildet ist aus Molybdän, Tantal, Zirkonium, Cobalt, Niob und/oder Wolfram und/oder mindestens einem Metallchalkogenid ausgewählt aus Metallselend, Metallsulfid und/oder Metallsulfoselenid mit Metall = Mo, W, Ta, Zr, Co oder Nb, insbesondere ausgewählt aus der Gruppe MoSe₂, WSe₂, TaSe₂, NbSe₂, Mo(Se₁₋ₓ,Sₓ)₂, W(Se₁₋ₓ,Sₓ)₂, Ta(Se₁₋ₓ,Sₓ)₂ und/oder Nb(Se₁₋ₓ,Sₓ)₂, wobei x beliebige Werte von 0 bis 1 annimmt.

Besonders vorteilhafte Resultate gehen mit einer solchen Verfahrensvariante einher, bei der die Kontaktschicht mindestens einen Dotierstoff für die Halbleiterabsorberschicht der Dünnschichtsolarzelle aufweist. Der Dotierstoff ist vorzugsweise ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod oder Fluor, und/oder mindestens eine Alkalimetallbronze, insbesondere Natrium- und/oder Kaliumbronze, vorzugsweise mit einem Metall ausgewählt aus Molybdän, Wolfram, Tantal und/oder Niob, aufweist.

Ferner weist die Kontaktschicht üblicherweise eine durchschnittliche Dicke von mindestens 5 nm und vorzugsweise nicht mehr als 150 nm, besonders bevorzugt von nicht mehr als 50 nm, auf.

Zweckmäßigerweise ist ferner vorgesehen, dass die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x beliebige Werte von 0 bis 1 annimmt. Den Kesterit-Schichten liegt in der Regel eine IB-IIA-IVA-VIA-Struktur zugrunde. Exemplarisch seien Cu₂ZnSnSe₄ und Cu₂ZnSnS₄ genannt. Hierbei kann in einer Verfahrensvariante vorgesehen sein, dass durch das Aufbringen der Kesterit- oder Chalkopyrit-Halbleiterabsorberschicht auf der Kontaktschicht in der Kontaktschicht vorliegende Metalle oder diese Kontaktschicht bildende Metalle vollständig oder partiell zu Metallseleniden, Metallsulfiden und/oder Metallsulfoseleniden umgewandelt werden.

Das erfindungsgemäße Verfahren kann ferner derart vorgenommen werden, dass die Kontaktschicht eine Schichtenabfolge umfasst aus mindestens einer Metallschicht und mindestens einer Metallchalkogenidschicht, wobei die Metallschicht an der Rückelektrodenschicht oder an der leitfähigen Barrierenschicht anliegt bzw. angrenzt und wobei die Metallchalkogenidschicht an der Halbleiterabsorberschicht anliegt bzw. angrenzt. Von Vorteil sind auch solche Vorgehensweisen, bei denen das Metall der Metallschicht und das Metall der Metallchalkogenidschicht übereinstimmen, insbesondere Molybdän und/oder Wolfram darstellen.

Eine weitere Ausgestaltung des erfindungsgemäßen Verfahrens sieht vor, dass auf die Barriereschicht mindestens eine erste Metalllage aus z.B. Molybdän, Tantal, Zirkonium, Cobalt, Wolfram und/oder Niob aufgebracht wird und dass diese erste Metalllage bei der Herstellung der Halbleiterabsorberschicht, insbesondere der Kesterit- oder Chalkopyrit-Halbleiterabsorberschicht, in Selen- und/oder Schwefel-haltiger Atmosphäre unter Ausbildung der Kontaktschicht teilweise zu einer Metallchalkogenidschicht umgesetzt wird.

Eine weitere Ausgestaltung des erfindungsgemäßen Verfahrens sieht ferner vor, dass auf die Barriereschicht mindestens eine erste Metalllage aus Molybdän, Tantal, Wolfram, Cobalt, Zirkonium und/oder Niob aufgebracht wird und dass diese erste Metalllage bei der Herstellung der Halbleiterabsorberschicht, insbesondere der Kesterit- oder Chalkopyrit-Halbleiterabsorberschicht, in Selen- und/oder Schwefel-haltiger Atmosphäre unter Ausbildung der Kontaktschicht vollständig zu einer Metallchalkogenidschicht umgesetzt wird.

Bei dem erfindungsgemäßen Verfahren umfasst in einer geeigneten Ausgestaltung der Schritt des Aufbringens der Halbleiterabsorberschicht, insbesondere der Kesterit- oder Chalkopyrit-Halbleiterabsorberschicht: die Abscheidung von, insbesondere sämtlichen, metallischen Komponenten der Halbleiterabsorberschicht, insbesondere von Kupfer, Indium und gegebenenfalls Gallium für die Chalkopyrit-Halbleiterabsorberschicht und Kupfer, Zink und Zinn für die Kesterit-Halbleiterabsorberschicht, auf der Kontaktschicht unter Ausbildung einer zweiten Metalllage und das Behandeln dieser zweiten Metalllage mit Selen und/oder einer Selenverbindung sowie gegebenenfalls mit Schwefel und/oder einer Schwefelverbindung, vorzugsweise bei Temperaturen oberhalb von 300°C, insbesondere oberhalb von 350°C.

Hierbei kann unter anderem auch vorgesehen sein, dass das beschichtete Substrat vor der Behandlung der zweiten Metalllage, insbesondere der Kupfer/Indium- bzw. Kupfer/Indium/Gallium-Metalllage oder der Kupfer/Zink/Zinn-Metalllage, mit Selen und/oder einer Selenverbindung sowie gegebenenfalls mit Schwefel und/oder einer Schwefelverbindung in mehrere Einzelmodule aufgetrennt, insbesondere geschnitten wird.

Die erste und/oder zweite Metalllage werden vorzugsweise erhalten mittels physikalischer Gasphasenabscheidung, insbesondere umfassend Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mittels chemischer Gasphasenabscheidung, insbesondere umfassend Chemical Vapour Deposition (CVD), Niedrigdruck- (low pressure) CVD und/oder Atmosphären- (atmospheric pressure) CVD.

Von Vorteil ist ferner eine solche Verfahrensvariante, bei der das Aufbringen der Rückelektrodenschicht, der leitfähigen Barriereschicht, der Kontaktschicht und der Metalle der Halbleiterabsorberschicht, insbesondere von Cu-, In und Ga-Schichten für die Bildung der Chalkopyrit-Halbleiterabsorberschicht oder von Cu-, Zn-, und Sn-Schichten für die Bildung der Kesterit-Halbleiterabsorberschicht, insbesondere in einer einzigen Vakuum-Beschichtungsanlage, vorzugsweise im Durchlauf-Sputterverfahren, erfolgt.

Die erste Pufferschicht kann sowohl trocken- wie auch nass-chemisch abgeschieden werden. Dabei kann die erste Pufferschicht enthalten oder im Wesentlichen gebildet sein aus CdS oder einer CdS-freien Schicht, insbesondere enthaltend oder im Wesentlichen aus Zn(S,OH) oder In₂S₃. Die zweite Pufferschicht enthält vorzugsweise oder ist im Wesentlichen gebildet aus intrinsisch leitendem Zinkoxid und/oder hochohmigem Zinkoxid.

Das für die Frontelektrode verwendete Material ist vorzugsweise transparent für elektromagnetische Strahlung, insbesondere für Strahlung mit einer Wellenlänge im Bereich des Absorptionswellenlängenbereichs des Halbleiters. Geeignete Frontelektrodenmaterialien für photovoltaische Dünnschichtsolarzellen sowie deren Applikation sind dem Fachmann bekannt. In einer Ausführungsform enthält die Frontelektrode oder ist im Wesentlichen gebildet aus n-dotiertem Zinkoxid.

Zweckmäßigerweise erfolgen in dem erfindungsgemäßen Verfahren die erste Laserbehandlung, die zweite Laserbehandlung und/oder die dritte Laserbehandlung mit Laserlichtpulsen mit einer Pulsdauer kleiner 10 nano-Sekunden, insbesondere kleiner 100 pico-Sekunden. Hierbei kann die zweite Laserbehandlung in einer zweckmäßigen Ausgestaltung von der der Pufferschicht zugewandten Seite vorgenommen werden.

In einer geeigneten Ausgestaltung ist vorgesehen, dass in dem zweiten und/oder dritten Strukturierungsschritt die zweiten bzw. dritten Trenngräben die sich von der Barriereschicht in Richtung der Halbleiterabsorberschicht oder Pufferschicht(en) erstrecken, mittels Laserbehandlung erzeugt werden. Die Laserbehandlung des ersten Strukturierungsschritts, insbesondere durch Laserablation, erfolgt vorzugsweise von der der beschichteten Seite des Substrats abgewandten Seite. In einer Ausführungsform kann die Ausbildung der dritten Trenngräben in dem dritten Strukturierungsschritt mittels mechanischer Strukturierung, insbesondere Nadelritzens, und/oder mittels einer dritten Laserbehandlung erfolgen.

In einer praktikablen Ausgestaltung ist vorgesehen, dass mindestens ein zweiter Trenngraben, insbesondere sämtliche zweiten Trenngräben, beabstandet benachbart zu jeweils einem verfüllten ersten Trenngraben vorliegen. Ferner kann vorgesehen sein, dass mindestens ein dritter Trenngraben, insbesondere sämtliche dritten Trenngräben, durch den jeweils korrespondierenden verfüllten zweiten Trenngraben oder ersten linienförmigen leitfähigen Bereich von dem jeweils korrespondierenden verfüllten ersten Trenngraben separiert ist.

Das erfindungsgemäße Verfahren sieht ferner vor, dass der erste, zweite und dritte Strukturierungsschritt zu einer monolithisch integrierten Serienverschaltung der Solarzellen führen oder beitragen und insbesondere als linienbildende bzw. Trenngräben bildende Prozessierschritte ausgestaltet sind.

Des Weiteren weisen die ersten, zweiten und/oder dritten Trenngräben in einer weiteren Ausgestaltung eine durchschnittliche Breite von nicht mehr als 30 µm, vorzugsweise von nicht mehr als 15 µm auf.

Das Substrat, das beim erfindungsgemäßen Verfahren zum Einsatz kommt, stellt vorzugsweise eine Platte oder Folie, insbesondere Glasplatte, mit einer Breite größer 0,5 m, insbesondere größer 2 m und besonders bevorzugt größer 3 m, und einer Länge größer 1,2 m, insbesondere größer 3 m und bevorzugt größer 5 m, dar. Beispielsweise ist es sogar möglich, Substratformate, insbesondere Substratglasformate, mit einer Breite von 3,2 m und einer Länge von 6 m zu verwenden. Hieraus lassen sich z.B. 16 Dünnschichtsolarmodule im Modulformat 1,6 m x 0,7 m erhalten.

Die der Erfindung zugrunde liegende Erfindung wird des Weiteren gelöst durch ein photovoltaisches Dünnschichtsolarmodul erhältlich nach dem erfindungsgemäßen Verfahren.

Nach dem erfindungsgemäßen Verfahren erhaltene photovoltaische Dünnschichtsolarmodule enthalten, in dieser Reihenfolge, vorzugsweise mindestens eine Substratschicht, mindestens eine Rückelektrodenschicht, mindestens eine leitfähige Barriereschicht, mindestens eine, insbesondere Ohm'sche, Kontaktschicht, mindestens eine, insbesondere an der Kontaktschicht unmittelbar anliegende, Halbleiterabsorberschicht, insbesondere Chalkopyrit- oder Kesterit-Halbleiterabsorberschicht, und mindestens eine Frontelektrode.

Dabei kann unter anderem vorgesehen sein, dass zwischen der Halbleiterabsorberschicht und der Frontelektrode mindestens eine Pufferschicht, insbesondere mindestens eine Schicht (erste Pufferschicht), enthaltend oder im Wesentlichen gebildet aus CdS oder einer CdS-freien Schicht, insbesondere enthaltend oder im Wesentlichen aus Zn(S,OH) oder In₂S₃, und/oder mindestens eine Schicht (zweite Pufferschicht), enthaltend und im Wesentlichen gebildet aus intrinsischem Zinkoxid und/oder hochohmigem Zinkoxid, vorliegt.

Besonders zweckmäßig sind dabei auch solche erfindungsgemäßen Dünnschichtsolarmodule, bei denen die Halbleiterabsorberschicht eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,S₁₋ₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x beliebige Werte von 0 bis 1 annimmt.

Eine zweckmäßige Ausgestaltung des erfindungsgemäßen Dünnschichtsolarmoduls sieht ferner vor, dass die Kontaktschicht mindestens eine Metallschicht und mindestens eine Metallchalkogenidschicht umfasst, wobei erstere zu der Rückelektrode benachbart ist bzw. an diese angrenzt oder zu der Barriereschicht benachbart ist bzw. an diese angrenzt, und letztere zu der Halbleiterabsorberschicht benachbart ist bzw. an diese angrenzt.

Bevorzugt basieren die Metallschicht und die Metallchalkogenidschicht auf dem gleichen Metall, insbesondere Molybdän und/oder Wolfram. Hierbei stellt die Kontaktschicht vorzugsweise eine Metallchalkogenidschicht dar.

Es hat sich als zweckmäßig erwiesen, wenn der Dotierstoff, insbesondere Natriumionen, in der Kontaktschicht und/oder in der Halbleiterabsorberschicht der die Rückelektrode aufweisenden Dünnschichtsolarzelle bzw. -modul in einer Dosis im Bereich von 10¹³ bis 10¹⁷ Atomen/cm², bevorzugt in einer Dosis im Bereich von 10¹⁴ bis 10¹⁶ Atomen/cm² vorliegt.

Für den Fall der Dotierung der Kontaktschicht mit Dotierstoffen für die Halbleiterabsorberschicht einer Dünnschichtsolarzelle hat sich die erfindungsgemäße Mehrschicht-Rückelektrode bewährt. Bei der Herstellung der Halbleiterabsorberschicht werden regelmäßig Temperaturen oberhalb von 300 bzw. oberhalb von 350°C eingesetzt. Häufig liegen diese Temperaturen auch im Bereich von 500°C bis 600°C. Bei derartigen Temperaturen migrieren, insbesondere diffundieren, Dotierstoffe, wie insbesondere Natriumionen bzw. Natriumverbindungen, aus der dotierten Kontaktschicht in die Halbleiterabsorberschicht. Bedingt durch die Barriereschicht findet eine Migration bzw. Diffusion in die Rückelektrodenschicht nicht statt.

Aufgrund der genannten relativ hohen Temperaturen bei der Prozessierung des Halbleiters ist es vorteilhaft, dass die ausgewählten Schichten der Mehrschichtrückelektrode, insbesondere die Bulk-Rückelektrode und/oder die leitfähige Barrierenschicht so zusammengesetzt sind, dass deren linearer thermischer Ausdehnungskoeffizient an den des Halbleiterabsorbers und/oder des Substrates angepasst sind. Daher sollten insbesondere die Bulk-Rückelektrode und/oder die Barriereschicht der erfindungsgemäßen Dünnschichtsolarzellen und -module vorzugsweise so zusammengesetzt sein, dass ein linearer thermischer Ausdehnungskoeffizient von 14^{∗}10⁻⁶⁻K, bevorzuget von 9^{∗}10^{-6 -}K nicht überschritten wird.

Aufgrund der genannten relativ hohen Temperaturen bei der Prozessierung des Halbleiters ist es vorteilhaft, dass die ausgewählten Schichten der Mehrschichtrückelektrode, insbesondere die Bulk-Rückelektrode und/oder die leitfähige Barrierenschicht so zusammengesetzt sind, dass deren linearer thermischer Ausdehnungskoeffizient an den des Halbleiterabsorbers und/oder des Substrates angepasst sind. Daher sollten insbesondere die Bulk-Rückelektrode und/oder die Barriereschicht der erfindungsgemäßen Dünnschichtsolarzellen und -module vorzugsweise so zusammengesetzt sein, dass ein linearer thermischer Ausdehnungskoeffizient von 14^{∗}10⁻⁶⁻K, bevorzuget von 9^{∗}10^{-6 -}K nicht überschritten wird.

Im Sinne der Erfindung ist vorzugsweise vorgesehen, dass die durchschnittliche Dicke der Bulk-Rückelektrodenschicht im Bereich von 50 nm bis 500 nm, insbesondere im Bereich von 80 nm bis 250 nm, und/oder die durchschnittliche Dicke der Barriereschicht im Bereich von 10 nm bis 250 nm, insbesondere im Bereich von 20 nm bis 150 nm, und/oder die durchschnittliche Dicke der Kontaktschicht im Bereich von 2 nm bis 200 nm, insbesondere im Bereich von 5 nm bis 100 nm, liegen. Dabei ist die Gesamtdicke der Mehrschicht-Rückelektrode vorzugsweise so einzustellen, dass der spezifische Gesamtwiderstand der erfindungsgemäßen Rückelektrode 50 microOhm^{∗}cm, bevorzugt 10 microOhm^{∗}cm, nicht überschreitet. Unter diesen Vorgaben lassen sich Ohm'sche Verluste in einem serienverschalteten Modul nochmals zu reduzieren.

Der vorliegenden Erfindung liegt die überraschende Erkenntnis zugrunde, dass sich durch die Abfolge der Strukturierungsprozesse, insbesondere in Kombination mit der vorgeschlagenen Mehrschicht-Rückelektrode, monolithisch integriert serienverschaltete Solarzellen in der Massenfertigung in hoher Qualität und mit hohen Wirkungsgraden kosteneffizient und reproduzierbar erhalten lassen. Bei aus dem Stand der Technik bekannten Herstellverfahren findet an den Strukturgrabenflanken der aufgetrennten Rückelektrode eine unerwünschte Reaktion mit Selen und/oder Schwefel bzw. mit Selen- und/oder Schwefelwasserstoff statt. Denn bei diesen bekannten Verfahren werden die Strukturiergräben vor dem Halbleiterbildungsprozess hergestellt, weshalb die Strukturiergräben unter Einwirkung der bei der Halbleiterbildung angewendeten hohen Temperaturen und gegebenenfalls auch Alkalidiffusion im Bereich von 350°C bis 600°C stehen und unter Selen- bzw. Schwefeleinwirkung dann häufig korrodieren. Hiermit einhergehend erfolgt eine Schichtunterwanderung und die Bildung von Mikrorissen durch mechanischen Stress, hervorgerufen durch die Volumenexpansion der unter Selen- und/oder Schwefeleinwirkung korrodierten Metalle. Mit dem erfindungsgemäßen Verfahren werden diese Nachteile umgangen. Das erfindungsgemäße Verfahren sieht u.a. in einer Ausgestaltung vor, eine Barrierenschicht für Chalkogene wie Selen und/oder Schwefel bzw. Chalkogenverbindungen einzusetzen und diese in zeitlicher Abfolge erst nach dem reaktiven Halbleiterbildungsprozess zu strukturieren. Mit dem erfindungsgemäßen Verfahren wird ferner umgangen, die Laserstrukturierung an z.B. einer Molybdänrückelektrode zu einem Zeitpunkt vornehmen zu müssen, bei dem sich Mikrorisse ebenso nicht vollständig vermeiden lassen wie das Aufschmelzen des Molybdäns am Strukturierungsrand. Beide Phänomene ermöglichen jedenfalls eine zumindest partielle Beeinträchtigung der Dünnschichtsolarzelle unter den Bildungsbedingungen der Halbleiterabsorberschicht. Das erfindungsgemäße Verfahren gestattet es zudem, die sonst häufig auftretende Schädigung der isolierenden Barriereschicht beim Laserprozess zu umgehen. Folglich kann verhindert werden, dass Alkaliionen unkontrolliert aus dem Substratglas in die Halbleiterabsorberschicht gelangen. Durch die Vermeidung der Überdotierung der Halbleiterabsorberschicht und durch das Verfüllen des Strukturiergrabens mit Isolatorfüllmaterial wird der gewünschte hohe Brückenwiderstand zwischen benachbarten Zellen gegenüber dem Stand der Technik deutlich verbessert, so dass ein signifikanter Füllfaktor- bzw. Wirkungsgradgewinn die Folge ist. Des Weiteren wird durch die kontrollierte Dotierung der Halbleiterabsorberschicht sichergestellt, dass durch Alkaliionen induzierte Haftungsprobleme der einzelnen Schichten bei dem nach dem erfindungsgemäßen Verfahren erhaltenen Dünnschichtsolarmodul nicht mehr auftreten. Der Anteil an nicht zu verwendender Ausschussware kann damit drastisch verringert werden.

Das erfindungsgemäße Verfahren ermöglicht darüber hinaus erstmalig den Einsatz einer leitfähigen Barriereschicht in Kombination mit der Bulk-Rückelektrode im Sinne der vorliegenden Erfindung bei monolithisch integrierter Serienverschaltung von Dünnschichtsolarzellen in photovoltaischen Dünnschichtsolarmodulen. Die erfindungsgemäß in Selen- und Schwefel-haltiger Atmosphäre regelmäßig nicht korrosionsbeständige Bulk-Rückelektrode wird während des Halbleiterherstellprozesses durch die noch nicht strukturierte bzw. noch nicht aufgetrennte Barrierenschicht geschützt. Ein Aufbrechen der Barrierenschicht und der darüberliegenden Absorberschicht am Strukturiergraben durch korrosionsbedingte Volumenexpansion der Bulk-Rückelektrodenschicht - typischer Weise um den Faktor 3 - kann so vermieden werden. Erst nach dem korrosiven HalbleiterBildungsprozess wird die Mehrschicht-Rückelektrode mit Halbleiterabsorberschicht und Pufferschicht strukturiert.

Des Weiteren gestattet es das erfindungsgemäße Verfahren, weniger reine Materialien für z.B. die Bulk-Rückelektrodenschicht zu verwenden. Hierdurch ist es möglich, das thermische Ausdehnungsverhalten der unterschiedlichen Materialschichten des Dünnschichtmoduls besser aufeinander abzustimmen. Dieses hat u.a. den positiven Effekt, dass während des Herstellverfahrens Ablösephänomene bzw. Haftungsprobleme noch weiter zurückgedrängt werden können.

Mit der vorliegenden Erfindung geht ferner die Erkenntnis einher, dass sich die Nachteile bei der Herstellung von Dünnschichtsolarmodulen nach dem Stand der Technik insbesondere auch dadurch überwinden lassen, dass der erste Strukturierungsschritt erst nach der Auftragung der Pufferschicht(en) erfolgt, vorzugsweise mittels Laserbehandlung. Die genannten vorteilhaften Effekte stellen sich insbesondere auch dann ein, wenn der beschriebene Strukturierungsmodus an einem solchen Dünnschichtsolarmodul bzw. einer Vorstufe eines Dünnschichtsolarmoduls vorgenommen wird, das mit der vorangehend beschriebenen Barriereschicht, insbesondere einer bidirektional wirkenden Barriereschicht, ausgestattet ist.

Von Vorteil ist weiterhin auch die überraschende Erkenntnis, dass sich der erste und der zweite Strukturierungsschritt sowie das Verfüllen des Strukturiergrabens mit Isolator in einer Anlage durchführen lassen, wodurch letztendlich geringere Linienabstände der Trenngräben möglich sind, was wiederum zu einer Erhöhung der aktiven Fläche der individuellen Solarzelle und damit auch zu einem erhöhten Wirkungsgrad des Dünnschichtsolarmoduls beiträgt. Als Verfahren zum Isolatorverfüllen sind z.B. sehr fein dosierbare Inkjet-Verfahren geeignet, wie sie aus der Tintenstrahl-Druckerindustrie bekannt sind. Als Verfüllmaterial kann zum Beispiel eine schnell härtende Isolatortinte oder ein UVhärtender elektrisch isolierender Lack verwendet werden, wie er aus der Halbleitertechnologie bekannt ist. Die UV-Beleuchtung erfolgt unmittelbar nach dem Verfüllschritt. Im Verfahren für die erste und die zweite Laserbehandlung kommen zum Beispiel Laserlichtpulse mit einer Pulsdauer kleiner 10 pico-Sekunden zum Einsatz. Der Linienvorschub ist mit Geschwindigkeiten von einigen m/s massenproduktionstauglich.

Weitere Merkmale und Vorteile der Erfindung ergeben sich aus der nachgehenden Beschreibung, in der bevorzugte Ausführungsformen der Erfindung beispielhaft anhand schematischer Zeichnungen erläutert sind. Dabei zeigen:
- Figur 1: eine schematisch Querschnittsansicht einer Fertigungsstufe eines erfindungsgemäßen Dünnschichtsolarmoduls in dem erfindungsgemäßen Verfahren;
- Figur 2: eine schematisch Querschnittsansicht einer nachfolgenden Fertigungsstufe eines erfindungsgemäßen Dünnschichtsolarmoduls in dem erfindungsgemäßen Verfahren;
- Figur 3: eine schematisch Querschnittsansicht einer weiteren Fertigungsstufe eines erfindungsgemäßen Dünnschichtsolarmoduls in dem erfindungsgemäßen Verfahren;
- Figur 4,: eine schematisch Querschnittsansicht einer weiteren Fertigungsstufe eines erfindungsgemäßen Dünnschichtsolarmoduls in dem erfindungsgemäßen Verfahren; und
- Figur 5: eine schematisch Querschnittsansicht einer weiteren Fertigungsstufe eines erfindungsgemäßen Dünnschichtsolarmoduls in dem erfindungsgemäßen Verfahren.

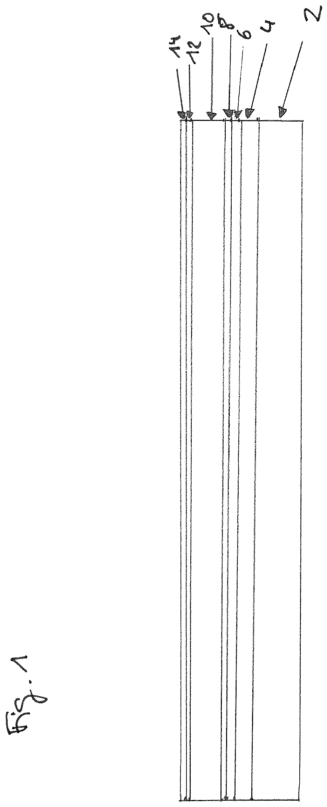

Figur 1 entnimmt man eine schematische Querschnittsansicht einer intermediären Fertigungsstufe 1a eines erfindungsgemäßen Dünnschichtsolarmoduls 1. Auf dem Glassubstrat 2 liegt mittels Dünnschichtabscheidung eine Bulk-Rückelektrodenschicht 4 aus Molybdän vor. Hieran angrenzend liegt eine bidirektionale, reflektierende Barriereschicht 6 aus z.B.

TiN oder ZrN auf, die ebenfalls mittels Dünnschichtabscheidung erhalten werden kann. Auf der Barriereschicht 6 liegt in der dargestellten Ausführungsform eine Ohm'sche Kontaktschicht 8 aus einem Metallchalkogenid wie Molybdänselenid auf. Diese Kontaktschicht kann auf unterschiedliche Art und Weise erhalten werden. In einer Ausgestaltung ist z.B. Molybdänselenid aus einem Molybdänselenidtarget aufgesputtert worden. Alternativ kann zunächst eine Metallschicht aufgetragen werden, welche anschließend vor und/oder während der Bildung der Halbleiterabsorberschicht in das entsprechende Metallchalkogenid umgewandelt wird. Die Kontaktschicht 8 kann dabei in einer bevorzugten Ausführungsform auch mit mindestens einem Dotierstoff versetzt sein, beispielsweise Natriumionen oder einer Natriumverbindung, insbesondere Natriumsulfit oder Natriumsulfid. Die Schicht 10 stellt die Halbleiterabsorberschicht dar und kann z.B. als Chalkopyrit- oder als Kesterit-Halbleiterabsorberschicht vorliegen. Verfahren zur Auftragung dieser Halbleiterabsorberschichten sind dem Fachmann bekannt. Liegt in der Kontaktschicht ein Dotierstoff vor, diffundiert dieser in der Regel unter den Bedingungen der Bildung der Halbleiterabsorberschicht in letztere. Mittels Dünnschichtabscheidung sind dann anschließend auf die Halbleiterabsorberschicht 10 zunächst die erste Pufferschicht 12 aus z.B. CdS, Zn(S,OH) oder In₂S₃ und anschließend die zweite Pufferschicht 14 aus intrinsischem Zinkoxid appliziert worden.

Die in Figur 1 dargestellte Fertigungsstufe 1a eines erfindungsgemäßen Dünnschichtsolarmoduls 1 ist in einer einzigen Anlage in einem im Wesentlichen Zusammenhängenden Prozess gefertigt worden. Während der gesamten Prozessspanne kann in einer einzigen Anlage prozessiert werden. Somit werden nicht nur kostenträchtige Verfahrensschritte vermieden, sondern ebenfalls die Gefahr der Kontamination der Produktzwischenstufen, beispielsweise mit Sauerstoff, reduziert.

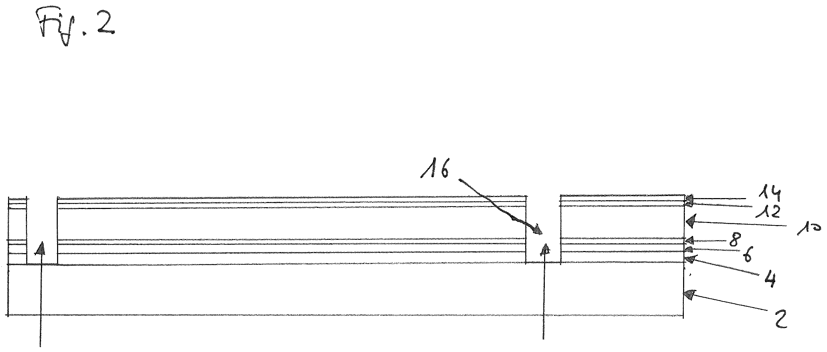

Figur 2 zeigt den an der Fertigungszwischenstufe 1a vorgenommenen ersten Strukturierungsschritt unter Erhalt der Fertigungsstufe 1b. Mittels Laserbehandlung von der Unterseite (angedeutet durch Pfeilsymbole) des transparenten Substrats 2 sind erste Trenngräben 16 erzeugt worden, welche letztendlich die Zellbreiten der monolithisch integrierten Serienverschaltung festlegen. Auf diese Weise sind z.B. über eine durchschnittliche Trenngrabenbreite von 15 µm entlang von Linien sämtliche oberhalb des Substrats vorliegenden Schichten entfernt worden.

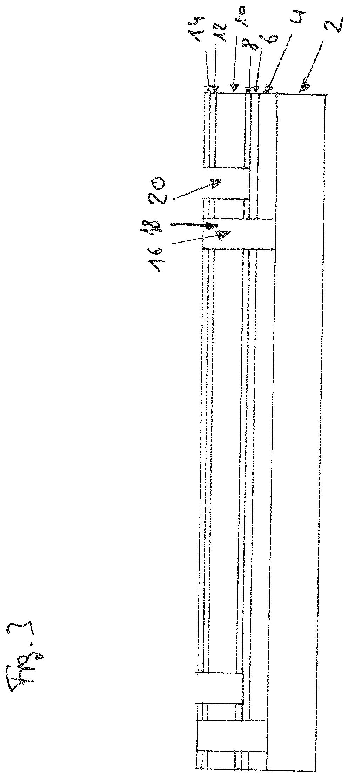

Die in Figur 3 wiedergegebene Fertigungsstufe 1c verfügt über mit einem aushärtbaren Isolationsmaterial 18 verfüllte Trenngräben 16, das sich in der dargestellten Ausführungsform bis an die Oberseite der zweiten Pufferschicht 14 erstreckt. Außerdem ist mittels Laserbehandlung ein zweiter Strukturierungsprozess an dem Schichtsystem, diesmal von der Oberseite, unter Ausbildung beabstandeter zweiter Trenngräben 20 vorgenommen worden. Von der zweiten Pufferschicht 14 über die Halbleiterabsorberschicht 10 bis einschließlich der Kontaktschicht 8 sind sämtliche Schichten entfernt worden, vorzugsweise über eine durchschnittliche Breite von 15 µm.

Die Schritte der ersten Laserstrukturierung, der Verfüllung der ersten Trenngräben und der zweiten Laserstrukturierung können hierbei bevorzugt in ein und derselben Anlage durchgeführt werden. Hierdurch entfällt eine aufwendige Justage, vielmehr muss diese nur ein einziges Mal erfolgen. Auch können die ersten und zweiten Trenngräben in einem engeren Abstand zueinander angebracht werden, wodurch die effektive Fläche des Dünnschichtsolarmoduls vergrößert wird.

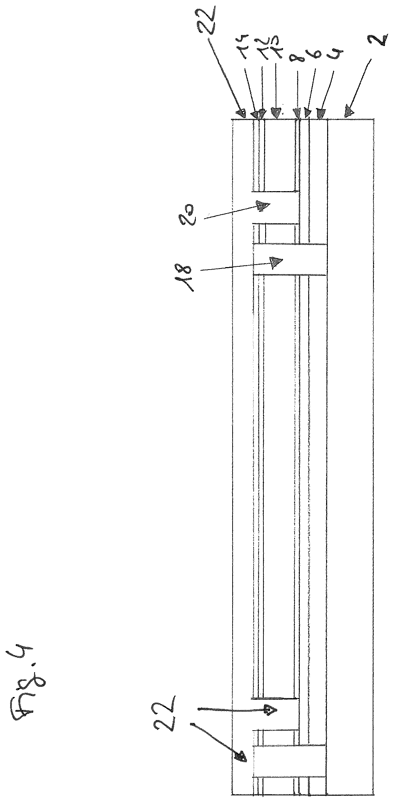

Auf die Fertigungsstufe 1c wird mittels bekannter Dünnschichtabscheidung, wie in Figur 4 gezeigt, eine transparente hochleitfähige Frontelektrodenschicht 22 aus z.B. n-dotiertem Zinkoxid unter Erhalt der Fertigungsstufe 1d aufgebracht. Das Frontelektrodenmaterial dringt dabei auch in die zweiten Trenngräben 20 ein.

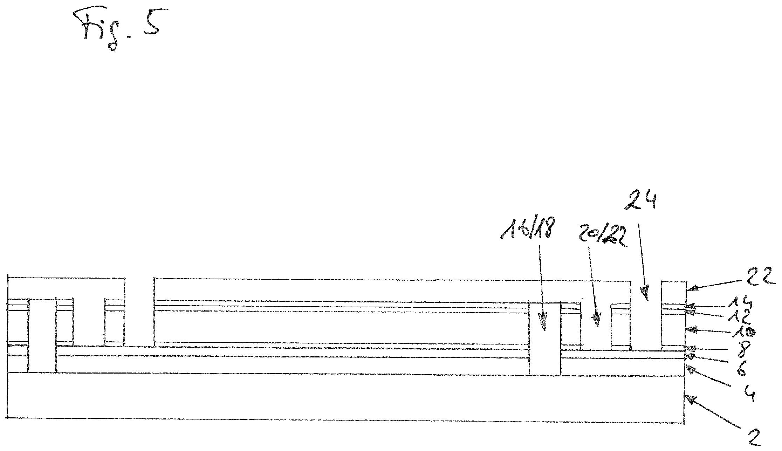

Schließlich wird die Fertigungsstufe 1d zwecks Definition der Isolationsstruktur in der monolithisch integrierten Serienverschaltung einem dritten Strukturierungsschritt unterzogen, bei dem dritte Trenngräben 24 erzeugt werden, die sich bis zur Barriereschicht 6 erstrecken (siehe Figur 5). Dieses kann mittels Laserbehandlung oder mechanisch, z.B. mittels Nadelritzens, erfolgen.

Bei dem dargestellten Verfahren können die Zielformate der Dünnschichtsolarmodule in einer zweckmäßigen Ausgestaltung mittels Schneidens aus dem Ursprungsformat des Substrats nach der Auftragung der Metalle der Halbleiterabsorberschicht und vor Behandeln dieser Metallschichten mit Chalkogenen unter erhöhter Temperatur erhalten werden.

Die in der vorstehenden Beschreibung, in den Ansprüchen sowie in den Zeichnungen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zur Herstellung von photovoltaischen Dünnschichtsolarmodulen, umfassend, in dieser Reihenfolge, die Schritte:
- Zurverfügungstellung eines, insbesondere flächigen, Substrats (2),
- Aufbringen einer Rückelektrodenschicht (4) auf dem Substrat (2),
- Aufbringen einer leitfähigen Barriereschicht (6),
- Aufbringen einer, insbesondere Ohm'schen, Kontaktschicht (8),
- Aufbringen einer, insbesondere Kesterit- oder Chalkopyrit-, Halbleiterabsorberschicht (10),
- gegebenenfalls Aufbringen einer ersten Pufferschicht (12),
- gegebenenfalls Aufbringen einer zweiten Pufferschicht (14),
**dadurch gekennzeichnet, dass** die Herstellung ferner die nachfolgenden Schritte umfasst:
- einen ersten Strukturierungsschritt, umfassend Entfernen der aufgebrachten Schichten entlang voneinander beabstandeter Linien mittels Laserbehandlung (erste Laserbehandlung) unter Ausbildung erster Trenngräben (16), welche benachbarte Solarzellen trennen,
- Füllen der ersten Trenngräben (16) mit mindestens einem isolierenden Material (18),
- einen zweiten Strukturierungsschritt, umfassend
-- Entfernen derjenigen Schichten, die sich von der Barriereschicht (6) in Richtung der Halbleiterabsorberschicht (10) oder Pufferschicht(en) (12, 14) erstrecken, entlang voneinander beabstandeter Linien, unter Ausbildung zweiter Trenngräben (20), welche zu korrespondierenden ersten Trenngräben (16) benachbart sind oder an diese angrenzen, insbesondere parallel zu diesen verlaufen,
- Aufbringen einer transparenten Frontelektrodenschicht (22) unter Verfüllung und Kontaktierung der zweiten Trenngräben (20), so dass benachbarte Solarzellen serienverschaltet werden, und
- einen dritten Strukturierungsschritt, umfassend Entfernen der Schichten, die sich von der Barriereschicht (6) in Richtung der Frontelektrodenschicht (22) erstrecken entlang voneinander beabstandeter Linien unter Ausbildung dritter Trenngräben (24), welche zu korrespondierenden zweiten Trenngräben (20) benachbart sind oder an diese angrenzen, insbesondere parallel zu diesen verlaufen, wobei die leitfähige Barriereschicht (6) eine bidirektional wirkende Barriereschicht darstellt für aus der und/oder über die Rückelektrodenschicht (4) migrierende Komponenten und für aus der und/oder über die Kontaktschicht (8) migrierende Komponenten.

2. Verfahren nach Anspruch 1, **dadurch gekennzeichnet, dass** das Substrat (2) zumindest bereichsweise für elektromagnetische Strahlung der ersten Laserbehandlung durchlässig ist und/oder dass die Laserbehandlung des ersten Strukturierungsschritts, insbesondere durch Laserablation, von der der beschichteten Seite des Substrats (2) abgewandten Seite erfolgt.

3. Verfahren nach Anspruch 1 oder 2, **dadurch gekennzeichnet, dass** die Kontaktschicht (8) mindestens ein Metall-Chalkogenid enthält oder eine Metallchalkogenidschicht darstellt.

4. Verfahren nach einem der vorangehenden Ansprüche, **dadurch gekennzeichnet, dass**
in dem zweiten und/oder dritten Strukturierungsschritt die zweiten bzw. dritten Trenngräben (20, 24) mittels Laserbehandlung erzeugt werden.

5. Verfahren nach einem der vorangehenden Ansprüche, **dadurch gekennzeichnet, dass**
mindestens ein zweiter Trenngraben (20), insbesondere sämtliche zweiten Trenngräben, beabstandet benachbart zu jeweils einem verfüllten ersten Trenngraben (16) vorliegen.

6. Verfahren nach einem der vorangehenden Ansprüche, **dadurch gekennzeichnet, dass**
mindestens ein dritter Trenngraben (24), insbesondere sämtliche dritten Trenngräben, durch den jeweils korrespondierenden verfüllten zweiten Trenngraben (20) von dem jeweils korrespondierenden verfüllten ersten Trenngraben (16) separiert ist.

7. Verfahren nach einem der vorangehenden Ansprüche, **dadurch gekennzeichnet, dass**
die Rückelektrodenschicht (4) enthält oder im Wesentlichen gebildet ist aus Wolfram, Chrom, Tantal, Niob, Vanadium, Mangan, Titan, Zirkonium, Cobalt und/oder Molybdän, vorzugsweise Wolfram, Titan und/oder Molybdän, oder aus einer Legierung enthaltend Wolfram, Chrom, Tantal, Niob, Vanadium, Mangan, Titan, Zirkonium, Cobalt, Eisen, Nickel, Aluminium und/oder Molybdän.

8. Verfahren nach einem der vorangehenden Ansprüche, **dadurch gekennzeichnet, dass**
die bidirektional wirkende Barriereschicht eine Barriere für aus der und/oder über die Rückelektrodenschicht (4) diffundierende bzw. diffundierbare Komponenten, insbesondere Dotierstoffe, und für aus der und/oder über die Kontaktschicht (8), insbesondere aus der Halbleiterabsorberschicht (10) diffundierende bzw. diffundierbare Komponenten, insbesondere Dotierstoffe, darstellt.

9. Verfahren nach einem der vorangehenden Ansprüche, **dadurch gekennzeichnet, dass**
die Barriereschicht (6) eine Barriere gegenüber Alkaliionen, insbesondere Natriumionen, Selen oder Selenverbindungen, Schwefel oder Schwefelverbindungen und/oder Metallen, insbesondere Eisen, Nickel und/oder Metallen der Halbleiterabsorberschicht (10), darstellt und/oder dass die Barriereschicht (6) enthält oder im Wesentlichen gebildet ist aus mindestens einem Metallnitrid, mindestens einem Metallsiliziumnitrid, mindestens einem Metallcarbid und/oder mindestens einem Metallborid, insbesondere aus TiN, TiSiN, TaSiN, MoN, MoSiN, TaN, WN, ZrN und/oder WSiN.

10. Verfahren nach einem der vorangehenden Ansprüche, **dadurch gekennzeichnet, dass**
die Kontaktschicht (8) unmittelbar an die Halbleiterabsorberschicht (10) angrenzt.

11. Verfahren nach einem der vorangehenden Ansprüche, **dadurch gekennzeichnet, dass**
die Kontaktschicht (8) enthält oder im Wesentlichen gebildet ist aus Molybdän, Tantal, Niob und/oder Wolfram und/oder mindestens einem Metallchalkogenid ausgewählt aus Metallselenid, Metallsulfid und/oder Metallsulfoselenid mit Metall = Mo, W, Ta, Zr, Co oder Niob, insbesondere ausgewählt aus der Gruppe bestehend aus MoSe₂, WSe₂, MoS₂, WS₂, Mo(Se₁₋ₓ,Sₓ)₂ und/oder W(Se₁₋ₓ,Sₓ)₂, wobei x Werte von 0 bis 1 annimmt.

12. Verfahren nach einem der vorangehenden Ansprüche, **dadurch gekennzeichnet, dass**
die Kontaktschicht (8) mindestens einen Dotierstoff für die Halbleiterabsorberschicht (10) der Dünnschichtsolarzelle, insbesondere ausgewählt aus der Gruppe Natrium, Kalium und Lithium und/oder mindestens eine Verbindung dieser Elemente, vorzugsweise mit Sauerstoff, Selen, Schwefel, Bor und/oder Halogenen, z.B. Jod oder Fluor, und/oder mindestens einer Alkalimetallbronze, insbesondere Natrium- und/oder Kaliumbronze, aufweist.

13. Verfahren nach einem der vorangehenden Ansprüche, **dadurch gekennzeichnet, dass**
die Halbleiterabsorberschicht (10) eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(Seₓ,S₁₋ₓ)₄-Schicht, z.B. eine Cu₂ZnSn(Se)₄- oder eine Cu₂ZnSn(S)₄-Schicht, darstellt oder umfasst, wobei x Werte von 0 bis 1 annimmt.

14. Verfahren nach einem der vorangehenden Ansprüche, **dadurch gekennzeichnet, dass**
durch das Aufbringen der Kesterit- oder Chalkopyrit-Halbleiterabsorberschicht (10) auf der Kontaktschicht (8) in der Kontaktschicht vorliegende Metalle oder diese Kontaktschicht bildende Metalle vollständig oder partiell zu Metallseleniden, Metallsulfiden und/oder Metallsulfoseleniden umgewandelt werden.

15. Verfahren nach einem der vorangehenden Ansprüche, **dadurch gekennzeichnet, dass**
die erste Pufferschicht (12) trocken- oder nasschemisch abgeschieden wird.

16. Verfahren nach einem der vorangehenden Ansprüche, **dadurch gekennzeichnet, dass**
die erste Pufferschicht (12) enthält oder im Wesentlichen gebildet ist aus CdS oder einer CdS-freien Schicht, insbesondere enthaltend oder im Wesentlichen aus Zn(S,OH) oder In₂S₃, und/oder dass die zweite Pufferschicht (14) enthält oder im Wesentlichen gebildet ist aus intrinsisch leitendem Zinkoxid und/oder hochohmigem Zinkoxid.

17. Verfahren nach einem der vorangehenden Ansprüche, **dadurch gekennzeichnet, dass**
die erste Laserbehandlung, die zweite Laserbehandlung und/oder die dritte Laserbehandlung mit Laserlichtpulsen mit einer Pulsdauer kleiner 10 nano-Sekunden, insbesondere kleiner 100 pico-Sekunden, erfolgt.

18. Verfahren nach einem der vorangehenden Ansprüche, **dadurch gekennzeichnet, dass**
die Frontelektrodenschicht (22) enthält oder im Wesentlichen gebildet ist aus n-dotiertem Zinkoxid.

19. Verfahren nach einem der vorangehenden Ansprüche, **dadurch gekennzeichnet, dass**
der erste, zweite und dritte Strukturierungsschritt zu einer monolithisch integrierten Serienverschaltung der Solarzellen führen oder beitragen und insbesondere als linienhafte Prozessierschritte ausgestaltet sind.

20. Verfahren nach einem der vorangehenden Ansprüche, **dadurch gekennzeichnet, dass**
die Ausbildung der dritten Trenngräben (24) in dem dritten Strukturierungsschritt mittels mechanischer Strukturierung, insbesondere Nadelritzens, und/oder mittels einer dritten Laserbehandlung erfolgt.

21. Verfahren nach Anspruch 3, **dadurch gekennzeichnet, dass**
das Metall des Metallchalkogenids ausgewählt ist aus der Gruppe bestehend aus Molybdän, Wolfram, Tantal, Cobalt, Zirkonium und/oder Niob und/oder dass das Chalkogen ausgewählt ist aus der Gruppe bestehend aus Selen und/oder Schwefel.

22. Verfahren nach einem der vorangehenden Ansprüche, **dadurch gekennzeichnet, dass**
auf die Barriereschicht (6) mindestens eine erste Metalllage aus Molybdän, Tantal, Wolfram, Cobalt, Zirkonium und/oder Niob aufgebracht wird und dass diese erste Metalllage bei der Herstellung der Halbleiterabsorberschicht (10), insbesondere der Kesterit- oder Chalkopyrit-Halbleiterabsorberschicht, in Selen- und/oder Schwefel-haltiger Atmosphäre unter Ausbildung der Kontaktschicht (8) teilweise zu einer Metallchalkogenidschicht umgesetzt wird.

23. Verfahren nach einem der Ansprüche 1 bis 22, **dadurch gekennzeichnet, dass**
auf die Barriereschicht (6) mindestens eine erste Metalllage aus Molybdän, Tantal, Wolfram, Cobalt, Zirkonium und/oder Niob aufgebracht wird und dass diese erste Metalllage bei der Herstellung der Halbleiterabsorberschicht (10), insbesondere der Kesterit- oder Chalkopyrit-Halbleiterabsorberschicht, in Selen- und/oder Schwefel-haltiger Atmosphäre unter Ausbildung der Kontaktschicht (8) vollständig zu einer Metallchalkogenidschicht umgesetzt wird.

24. Verfahren nach einem der vorangehenden Ansprüche, **dadurch gekennzeichnet, dass**
die Barriereschicht (6) eine durchschnittliche Dicke von mindestens 10 nm, insbesondere mindestens 30 nm und vorzugsweise von maximal 250 nm oder 150 nm,
aufweist und/oder dass die Kontaktschicht (8) eine durchschnittliche Dicke von mindestens 5 nm und vorzugsweise nicht mehr als 150 nm, besonders bevorzugt von nicht mehr als 50 nm, aufweist.

25. Verfahren nach einem der vorangehenden Ansprüche, **dadurch gekennzeichnet, dass**
die ersten, zweiten und/oder dritten Trenngräben (16, 20, 24) eine durchschnittliche Breite von nicht mehr als 30 µm, vorzugsweise von nicht mehr als 15 µm aufweisen.

26. Verfahren nach einem der vorangehenden Ansprüche, **dadurch gekennzeichnet, dass**
das Substrat (2) eine Glasplatte mit einer Breite größer 0,5 m, insbesondere größer 2,0 m, und einer Länge größer 1,2 m, insbesondere größer 3,0 m, darstellt.

27. Verfahren nach einem der vorangehenden Ansprüche, **dadurch gekennzeichnet, dass**
der Schritt des Aufbringens der Halbleiterabsorberschicht (10), insbesondere der Kesterit- oder Chalkopyrit-Halbleiterabsorberschicht, umfasst: die Abscheidung von, insbesondere sämtlichen, metallischen Komponenten der Halbleiterabsorberschicht (10), insbesondere von Kupfer, Indium und gegebenenfalls Gallium für die Chalkopyrit-Halbleiterabsorberschicht und Kupfer, Zink und Zinn für die Kesterit-Halbleiterabsorberschicht, auf der Kontaktschicht (8) unter Ausbildung einer zweiten Metalllage und das Behandeln dieser zweiten Metalllage mit Selen und/oder einer Selenverbindung sowie gegebenenfalls mit Schwefel und/oder einer Schwefelverbindung.

28. Verfahren nach Anspruch 27, **dadurch gekennzeichnet, dass** das beschichtete Substrat (2) vor der Behandlung der zweiten Metalllage, insbesondere der Kupfer/Indium- bzw. Kupfer/Indium/Gallium-Metalltage oder der Kupfer/Zink/Zinn-Metalllage, mit Selen und/oder einer Selenverbindung sowie gegebenenfalls mit Schwefel und/oder einer Schwefelverbindung in mehrere Einzelmodule aufgetrennt, insbesondere geschnitten wird.

29. Verfahren nach Anspruch 27 oder nach Anspruch 28, **dadurch gekennzeichnet, dass**
die erste und/oder zweite Metalllage erhalten werden mittels physikalischer Gasphasenabscheidung, insbesondere umfassend Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere DC- oder RF-Magnetron-Sputtern, jeweils vorzugsweise in einem Hochvakuum, oder mitttles chemischer Gasphasenabscheidung, insbesondere umfassend Chemical Vapour Deposition (CVD), Niedrigdruck- (low pressure) CVD und/oder Atmosphären- (atmospheric pressure) CVD.

30. Verfahren nach einem der vorangehenden Ansprüche, **dadurch gekennzeichnet, dass**
das Aufbringen der Rückelektrodenschicht (4), der leitfähigen Barriereschicht (6), der Kontaktschicht (8) und der Metalle der Halbleiterabsorberschicht (10), insbesondere von Cu-, In und Ga-Schichten für die Bildung der Chalkopyrit-Halbleiterabsorberschicht oder von Cu-, Zn-, und Sn-Schichten für die Bildung der Kesterit-Halbleiterabsorberschichtin einer einzigen Vakuum-Beschichtungsanlage, vorzugsweise im Durchlauf-Sputterverfahren, erfolgt.

31. Photovoltaisches Dünnschichtsolarmodul, hergestellt gemäß einem Verfahren nach einem der vorangehenden Ansprüche, umfassend, in dieser Reihenfolge, eine Substratschicht (2), eine Rückelektrodenschicht (4), eine leitfähige Barriereschicht (6), eine, insbesondere Ohm'sche, Kontaktschicht, eine, insbesondere an der Kontaktschicht (8) unmittelbar anliegende, Halbleiterabsorberschicht (10), insbesondere Chalkopyrit- oder Kesterit-Halbleiterabsorberschicht, gegebenenfalls eine Pufferschicht, insbesondere eine Schicht (erste Pufferschicht (12)), enthaltend oder im Wesentlichen gebildet aus CdS oder einer CdS-freien Schicht, insbesondere enthaltend oder im Wesentlichen aus Zn(S,OH) oder In₂S₃, und/oder gegebenenfalls eine Schicht (zweite Pufferschicht (14)), enthaltend und im Wesentlichen gebildet aus intrinsischem Zinkoxid und/oder hochohmigem Zinkoxid,
und eine Frontelektrodenschicht (22),
wobei die leitfähige Barriereschicht (6) eine bidirektional wirkende Barriereschicht darstellt für aus der und/oder über die Rückelektrodenschicht (4) migrierende Komponenten und für aus der und/oder über die Kontaktschicht (8) migrierende Komponenten.

32. Dünnschichtsolarmodul nach Anspruch 31, **dadurch gekennzeichnet, dass** die Halbleiterabsorberschicht (10) eine quaternäre IB-IIIA-VIA-Chalkopyritschicht, insbesondere eine Cu(In,Ga)Se₂-Schicht, eine penternäre IB-IIIA-VIA-Chalkopyritschicht, insbesondere eine Cu(In,Ga)(Se₁₋ₓ,Sₓ)₂-Schicht, oder eine Kesterit-Schicht, insbesondere eine Cu₂ZnSn(SeₓS₁₋ₓ)₄-Schicht, z.B. eine Cu₂ZnSn(Se)₄- oder eine Cu₂ZnSn(S)₄-Schicht, darstellt oder umfasst, wobei x Werte von 0 bis 1 annimmt.

## Claims

1. A method for producing photovoltaic thin-film solar modules, comprising, in this order, the steps:
- providing an, in particular, flat substrate (2),
- applying a back electrode layer (4) onto the substrate (2),
- applying a conductive barrier layer (6),
- applying an, in particular ohmic, contact layer (8),
- applying a, in particular kesterite or chalcopyrite, semiconductor absorber layer (10),
- if necessary applying a first buffer layer (12),
- if necessary applying a second buffer layer (14),
**characterised in that** the production further comprises the following steps:
- a first structuring step, comprising removing the applied layers along mutually spaced lines by means of laser treatment (first laser treatment) during formation of the first channels (16), which separate adjacent solar cells,
- filling the first channels (16) with at least one insulating material (18),
- a second structuring step, comprising
-- removing the layers which extend from the barrier layer (6) in the direction of the semiconductor absorber layer (10) or buffer layer(s) (12, 14), along mutually spaced lines, during formation of the second channels (20) which are adjacent to corresponding first channels (16) or adjoin these, in particular run parallel to these,
- applying a transparent front electrode layer (22) during filling and contacting the second channels (20), so that adjacent solar cells are connected in series, and
- a third structuring step comprising removing the layers which extend from the barrier layer (6) in the direction of the front electrode layer (22) along mutually spaced lines during formation of the third channels (24), which are adjacent to corresponding second channels (20) or adjoin these, in particular run parallel to these, wherein the conductive barrier layer (6) is a bidirectional barrier layer for components migrating from and/or through the back electrode layer (4) and for components migrating from and/or through the contact layer (8).

2. The method according to Claim 1, **characterised in that** the substrate (2) is at least partly permeable to the electromagnetic radiation of the first laser treatment and/or **in that** the laser treatment of the first structuring step is, in particular by laser ablation, performed from the side facing away from the coated side of the substrate (2).

3. The method according to Claim 1 or 2, **characterised in that** the contact layer (8) contains at least one metal chalcogenide or is a metal chalcogenide layer.

4. The method according to any one of the preceding claims, **characterised in that** in the second and/or third structuring step the second or third channels (20, 24) are created by means of laser treatment.

5. The method according to any one of the preceding claims, **characterised in that** at least one second channel (20), in particular all second channels, are each spaced apart adjacent to a respective filled first channel (16).

6. The method according to any one of the preceding claims, **characterised in that** at least one third channel (24), in particular all third channels, is separated by the corresponding filled second channel (20) from the corresponding filled first channel (16) respectively.

7. The method according to any one of the preceding claims, **characterised in that** the back electrode layer (4) contains or is essentially made of tungsten, chromium, tantalum, niobium, vanadium, manganese, titanium, zirconium, cobalt and/or molybdenum, preferably tungsten, titanium and/or molybdenum, or from an alloy containing tungsten, chromium, tantalum, niobium, vanadium, manganese, titanium, zirconium, cobalt, iron, nickel, aluminium and/or molybdenum.

8. The method according to any one of the preceding claims, **characterised in that** the bidirectional barrier layer is a barrier for components, in particular dopants, that diffuse or are diffusible from and/or through the back electrode layer (4), and for components, in particular dopants, that diffuse or are diffusible from and/or through the contact layer (8), in particular from the semiconductor absorber layer (10).

9. The method according to any one of the preceding claims, **characterised in that** the barrier layer (6) is a barrier to alkali ions, in particular sodium ions, selenium or selenium compounds, sulphur or sulphur compounds and/or metals, in particular iron, nickel and/or metals of the semiconductor absorber layer (10), and/or the barrier layer (6) contains or is essentially made of at least one metal nitride, at least one metal silicon nitride, at least one metal carbide and/or at least one metal boride, in particular from TiN, TiSiN, TaSiN, MoN, MoSiN, TaN, WN, ZrN and/or WSiN.

10. The method according to any one of the preceding claims, **characterised in that** the contact layer (8) directly adjoins the semiconductor absorber layer (10).

11. The method according to any one of the preceding claims, **characterised in that** the contact layer (8) contains or is essentially made of molybdenum, tantalum, niobium and/or tungsten and/or at least one metal chalcogenide selected from metal selenide, metal sulphide and/or metal sulphoselenide with metal = Mo, W, Ta, Zr, Co or niobium, in particular selected from a group consisting of MoSe₂, WSe₂, MoS₂, WS₂, Mo(Se₁₋ₓ,Sₓ)₂ and/or W(Se₁₋ₓ,Sₓ)₂, wherein x has values from 0 to 1.

12. The method according to any one of the preceding claims, **characterised in that** the contact layer (8) has at least one dopant for the semiconductor absorber layer (10) of the thin-film solar cell, in particular selected from the group sodium, potassium and lithium and/or at least one compound of these elements, preferably with oxygen, selenium, sulphur, boron and/or halogens, e.g. iodine or fluorine, and/or at least one alkali metal bronze, in particular sodium and/or potassium bronze.

13. The method according to any one of the preceding claims, **characterised in that** the semiconductor absorber layer (10) is or comprises a quaternary IB-IIIA-VIA chalcopyrite layer, in particular a Cu(In,Ga)Se₂-layer, a penternary IB-IIIA-VIA chalcopyrite layer, in particular a Cu(In,Ga)(Se₁₋ₓ,Sₓ)₂ layer, or a kesterite layer, in particular a Cu₂ZnSn(Seₓ, S₁₋ₓ)₄ layer, e.g. a Cu₂ZnSn(Se)₄ or a Cu₂ZnSn(S)₄ layer, wherein x has values from 0 to 1.

14. The method according to any one of the preceding claims, **characterised in that** by applying the kesterite or chalcopyrite semiconductor absorber layer (10) onto the contact layer (8), metals present in the contact layer or metals forming said contact layer are converted fully or partially into metal selenides, metal sulphides and/or metal sulphoselenides.

15. The method according to any one of the preceding claims, **characterised in that** the first buffer layer (12) is deposited dry or wet chemically.

16. The method according to any one of the preceding claims, **characterised in that** the first buffer layer (12) contains or is essentially made of CdS or a CdS-free layer, in particular containing or essentially made of Zn(S,OH) or In₂S₃, and/or **in that** the second buffer layer (14) contains or is essentially made of intrinsically conducting zinc oxide and/or high-resistance zinc oxide.

17. The method according to any one of the preceding claims, **characterised in that** the first laser treatment, the second laser treatment and/or the third laser treatment is/are performed by laser pulses with a pulse length of less than 10 nanoseconds, in particular less than 100 picoseconds.

18. The method according to any one of the preceding claims, **characterised in that** the front electrode layer (22) contains or is essentially made of n-doped zinc oxide.

19. The method according to any one of the preceding claims, **characterised in that** the first, second and third structuring steps lead or contribute to a monolithically integrated series connection of the solar cells and are in particular configured as linear processing steps.

20. The method according to any one of the preceding claims, **characterised in that** the formation of the third channels (24) in the third structuring step is performed by means of mechanical structuring, in particular needle scratching and/or by means of a third laser treatment.

21. The method according to Claim 3, **characterised in that** the metal of the metal chalcogenide is selected from a group consisting of molybdenum, tungsten, tantalum, cobalt, zirconium and/or niobium and/or **in that** the chalcogen is selected from a group consisting of selenium and/or sulphur.

22. The method according to any one of the preceding claims, **characterised in that** at least one first metal coat made of molybdenum, tantalum, tungsten, cobalt, zirconium and/or niobium is applied onto the barrier layer (6) and **in that** said first metal coat during the formation of the semiconductor absorber layer (10), in particular of the kesterite or chalcopyrite semiconductor absorber layer, is partly converted to a metal chalcogenide layer in a selenium and/or sulphur-containing atmosphere under formation of the contact layer (8).

23. The method according to any of Claims 1 to 22, **characterised in that** at least one first metal coat of molybdenum, tantalum, tungsten, cobalt, zirconium and/or niobium is applied onto the barrier layer (6) and **in that** said first metal coat during the formation of the semiconductor absorber layer (10), in particular of the kesterite or chalcopyrite semiconductor absorber layer, is fully converted into a metal chalcogenide layer in a selenium and/or sulphur-containing atmosphere under formation of the contact layer (8).

24. The method according to any one of the preceding claims, **characterised in that** the barrier layer (6) has an average thickness of at least 10 nm, in particular at least 30 nm and preferably a maximum of 250 nm or 150 nm, and/or **in that** the contact layer (8) has an average thickness of at least 5 nm and preferably not more than 150 nm, in particular preferably not more than 50 nm.

25. The method according to any one of the preceding claims, **characterised in that** the first, second and/or third channels (16, 20, 24) has/have an average width of not more than 30 µm, preferably not more than 15 µm.

26. The method according to any one of the preceding claims, **characterised in that** the substrate (2) is a glass plate with a width greater than 0.5 m, in particular greater than 2.0 m, and a length greater than 1.2 m, in particular greater than 3.0 m.

27. The method according to any one of the preceding claims, **characterised in that** the step of applying the semiconductor absorber layer (10), in particular the kesterite or chalcopyrite semiconductor absorber layer, comprises:
depositing, in particular all, metal components of the semiconductor absorber layer (10), in particular copper, indium and if necessary gallium for the chalcopyrite semiconductor absorber layer and copper, zinc and tin for the kesterite semiconductor absorber layer, onto the contact layer (8) under formation of a second metal coat and treating said second metal coat with selenium and/or a selenium compound and if necessary with sulphur and/or a sulphur compound.

28. The method according to Claim 27, **characterised in that** the layered substrate (2) before the treatment of the second metal coat, in particular the copper/indium or copper/indium/gallium metal coat or the copper/zinc/tin metal coat, with selenium and/or a selenium compound and if necessary with sulphur and/or a sulphur compound is divided, in particular cut, into several individual modules.

29. The method according to Claim 27 or according to Claim 28, **characterised in that** the first and/or second metal coat is obtained by means of physical gas phase deposition, in particular comprising physical vapour deposition (PVD), evaporation deposition by means of an electron beam vaporiser, evaporation deposition by means of a resistance evaporator, induction evaporation, ARC evaporation and/or cathode sputtering (sputter coating), in particular DC or RF magnetron sputtering, preferably in a high vacuum in each case or by means of chemical gas phase deposition, in particular comprising chemical vapour deposition (CVD), low pressure CVD and/or atmospheric pressure CVD.

30. The method according to any one of the preceding claims, **characterised in that** the application of the back electrode layer (4), the conductive barrier layer (6), the contact layer (8) and the metals of the semiconductor absorber layer (10), in particular Cu, In and Ga layers for forming the chalcopyrite semiconductor absorber layer or Cu, Zn, and Sn layers for forming the kesterite semiconductor absorber layer is performed in a single vacuum coating machine, preferably in a run-through sputtering process.

31. The photovoltaic thin-film solar module produced according to a method according to any one of the preceding claims comprising, in this order, a substrate layer (2), a back electrode layer (4), a conductive barrier layer (6), an, in particular ohmic, contact layer, a semiconductor absorber layer (10), in particular directly adjoining the contact layer (8), in particular a chalcopyrite or kesterite semiconductor absorber layer, if necessary a buffer layer, in particular a layer (first buffer layer (12)), containing or essentially made of CdS or a CdS-free layer, in particular containing or essentially made of Zn(S,OH) or In₂S₃, and/or if necessary a layer (second buffer layer (14)), containing and essentially made of intrinsic zinc oxide and/or high-resistance zinc oxide, and a front electrode layer (22), wherein the conductive barrier layer (6) is a bidirectional barrier layer for components migrating from and/or through the back electrode layer (4) and components migrating from and/or through the contact layer (8).

32. The thin-film solar module according to Claim 31, **characterised in that** the semiconductor absorber layer (10) is or comprises a quaternary IB-IIIA-VIA chalcopyrite layer, in particular a Cu(In,Ga)Se₂-layer, a penternary IB-IIIA-VIA chalcopyrite layer, in particular a Cu(In,Ga)(Se₁₋ₓ,Sₓ)₂ layer, or a kesterite layer, in particular a Cu₂ZnSn(Seₓ,S₁₋ₓ)₄ layer, e.g. a Cu₂ZnSn(Se)₄ or a Cu₂ZnSn(S)₄ layer, wherein x has values from 0 to 1.

## Revendications

1. Procédé de fabrication de modules solaires photovoltaïques à couche mince, comprenant, dans cet ordre, les étapes:
- mise à disposition d'un substrat (2), en particulier plat,
- application d'une couche d'électrode arrière (4) sur le substrat (2),
- application d'une couche barrière conductrice (6),
- application d'une couche de contact (8), en particulier ohmique,
- application d'une couche absorbante semi-conductrice (10), en particulier de kësterite ou de chalcopyrite,
- application éventuellement d'une première couche tampon (12),
- application éventuellement d'une seconde couche tampon (14),
**caractérisé en ce que** la fabrication comprend en outre les étapes suivantes :
- une première étape de structuration, comprenant l'enlèvement des couches appliquées le long de lignes distantes les unes des autres, au moyen d'un traitement au laser (premier traitement au laser) en formant des premières rainures de séparation (16), qui séparent des cellules solaires voisines,
- remplissage des premières rainures de séparation (16) avec au moins un matériau isolant (18),
- une deuxième étape de structuration, comprenant
-- enlèvement des couches qui s'étendent depuis la couche barrière (6) en direction de la couche absorbante semi-conductrice (10) ou de la (des) couche(s) tampon(s) (12, 14), le long de lignes distantes les unes des autres, en formant des deuxièmes rainures de séparation (20), qui sont voisines de premières rainures de séparation correspondantes (16) ou sont adjacentes à celles-ci, en particulier sont parallèles à celles-ci,
- application d'une couche d'électrode frontale transparente (22) en remplissant et en venant au contact des deuxièmes rainures de séparation (20), de sorte que des cellules solaires voisines soient montées en série, et
- une troisième étape de structuration, comprenant l'enlèvement des couches qui s'étendent depuis la couche barrière (6) en direction de la couche d'électrode frontale (22) le long de lignes distantes les unes des autres en formant des troisièmes rainures de séparation (24), qui sont voisines de deuxièmes rainures de séparation correspondantes (20) ou sont adjacentes à celles-ci, en particulier sont parallèles à celles-ci,
dans lequel la couche barrière conductrice (6) représente une couche barrière à action bidirectionnelle pour des composants migrant hors de et/ou par la couche d'électrode arrière (4) et pour des composants migrant hors de et/ou par la couche de contact (8).

2. Procédé selon la revendication 1, **caractérisé en ce que**
le substrat (2) est perméable, au moins par endroits, au rayonnement électromagnétique du premier traitement au laser et/ou **en ce que** le traitement au laser de la première étape de structuration se fait en particulier par ablation au laser du côté opposé au côté du substrat (2) recouvert de couches.

3. Procédé selon la revendication 1 ou 2, **caractérisé en ce que**
la couche de contact (8) contient au moins un chalcogénure métallique ou représente une couche de chalcogénure métallique.

4. Procédé selon l'une quelconque des revendications précédentes, **caractérisé en ce que**
dans la deuxième et/ou troisième étape de structuration, les deuxièmes respectivement troisièmes rainures de séparation (20, 24) sont produites au moyen d'un traitement au laser.

5. Procédé selon l'une quelconque des revendications précédentes, **caractérisé en ce qu'**
au moins une deuxième rainure de séparation (20), en particulier l'ensemble des deuxièmes rainures de séparation, sont espacées, voisines respectivement d'une première rainure de séparation remplie (16).

6. Procédé selon l'une quelconque des revendications précédentes, **caractérisé en ce qu'**
au moins une troisième rainure de séparation (24), en particulier l'ensemble des troisièmes rainures de séparation, est séparée de la première rainure de séparation remplie (16) respectivement correspondante par l'intermédiaire de la deuxième rainure de séparation remplie (20) respectivement correspondante.

7. Procédé selon l'une quelconque des revendications précédentes, **caractérisé en ce que**
la couche d'électrode arrière (4) contient ou est formée essentiellement de tungstène, de chrome, de tantale, de niobium, de vanadium, de manganèse, de titane, de zirconium, de cobalt et/ou de molybdène, de préférence de tungstène, de titane et/ou de molybdène, ou d'un alliage contenant du tungstène, du chrome, du tantale, du niobium, du vanadium, du manganèse, du titane, du zirconium, du cobalt, du fer, du nickel, de l'aluminium et/ou du molybdène.

8. Procédé selon l'une quelconque des revendications précédentes, **caractérisé en ce que**
la couche barrière à action bidirectionnelle représente une barrière pour des composants, en particulier des dopants, diffusant ou pouvant être diffusés hors de et/ou par la couche d'électrode arrière (4), et pour des composants, en particulier des dopants, diffusant ou pouvant être diffusés hors de et/ou par la couche de contact (8), en particulier hors de la couche absorbante semi-conductrice (10).

9. Procédé selon l'une quelconque des revendications précédentes, **caractérisé en ce que**
la couche barrière (6) représente une barrière vis-à-vis des ions alcalins, en particulier des ions sodium, du sélénium ou des composés de sélénium, du soufre ou des composés de soufre et/ou des métaux, en particulier du fer, du nickel et/ou des métaux de la couche absorbante semi-conductrice (10), et/ou **en ce que** la couche barrière (6) contient, ou est formée essentiellement de, au moins un nitrure métallique, au moins un nitrure de silicium métallique, au moins un carbure métallique et/ou au moins un borure métallique, en particulier TiN, TiSiN, TaSiN, MoN, MoSiN, TaN, WN, ZrN et/ou WSiN.

10. Procédé selon l'une quelconque des revendications précédentes, **caractérisé en ce que**
la couche de contact (8) est directement adjacente à la couche absorbante semi-conductrice (10).

11. Procédé selon l'une quelconque des revendications précédentes, **caractérisé en ce que**
la couche de contact (8) contient, ou est formée essentiellement de, molybdène, de tantale, de niobium et/ou de tungstène et/ou au moins un chalcogénure métallique sélectionné parmi le séléniure métallique, le sulfure métallique et/ou le séléniure de soufre métallique avec le métal = Mo, W, Ta, Zr, Co ou le niobium, en particulier sélectionné parmi le groupe se composant de MoSe₂, WSe₂, MoS₂, WS₂, Mo(Se₁₋ₓ,Sₓ)₂ et/ou W(Se₁₋ₓ,Sₓ)₂, x prenant des valeurs de 0 à 1.

12. Procédé selon l'une quelconque des revendications précédentes, **caractérisé en ce que**
la couche de contact (8) présente au moins un dopant pour la couche absorbante semi-conductrice (10) de la cellule solaire à couche mince, en particulier sélectionné parmi le groupe se composant de sodium, potassium et lithium et/ou au moins un composé de ces éléments, de préférence avec de l'oxygène, du sélénium, du soufre, du bore et/ou des halogènes, par exemple de l'iode ou du fluor, et/ou au moins un bronze de métal alcalin, en particulier du bronze de sodium et/ou du bronze de potassium.

13. Procédé selon l'une quelconque des revendications précédentes, **caractérisé en ce que**
la couche absorbante semi-conductrice (10) représente ou comprend une couche de chalcopyrite IB-IIIA-VIA quaternaire, en particulier une couche de Cu(In,Ga)Se₂, une couche de chalcopyrite IB-IIIA-VIA quinternaire, en particulier une couche de Cu(In,Ga)(Se₁₋ₓ,Sₓ)₂, ou une couche de kësterite, en particulier une couche de Cu₂ZnSn(Seₓ,S₁₋ₓ)₄, par exemple une couche Cu₂ZnSn(Se)₄ ou une couche Cu₂ZnSn(S)₄, x prenant des valeurs de 0 à 1.

14. Procédé selon l'une quelconque des revendications précédentes, **caractérisé en ce que**
par l'application de la couche absorbante semi-conductrice de kësterite ou de chalcopyrite (10) sur la couche de contact (8), les métaux présents dans la couche de contact ou les métaux formant cette couche de contact sont totalement ou partiellement transformés en séléniures métalliques, en sulfures métalliques et/ou en séléniures de soufre métalliques.

15. Procédé selon l'une quelconque des revendications précédentes, **caractérisé en ce que**
la première couche tampon (12) est déposée chimiquement par voie sèche ou humide.

16. Procédé selon l'une quelconque des revendications précédentes, **caractérisé en ce que**
la première couche tampon (12) contient, ou est formée essentiellement de, CdS ou une couche dépourvue de CdS, en particulier contenant, ou formée essentiellement de, Zn(S,OH) ou In₂S₃, et/ou **en ce que** la seconde couche tampon (14) contient ou est formée essentiellement d'oxyde de zinc conducteur intrinsèque et/ou d'oxyde de zinc avec résistance élevée.

17. Procédé selon l'une quelconque des revendications précédentes, **caractérisé en ce que**
le premier traitement au laser, le deuxième traitement au laser et/ou le troisième traitement au laser se fait avec des impulsions de lumière laser d'une durée d'impulsion inférieure à 10 nanosecondes, en particulier inférieure à 100 pico-secondes.

18. Procédé selon l'une quelconque des revendications précédentes, **caractérisé en ce que**
la couche d'électrode frontale (22) contient ou est formée essentiellement d'oxyde de zinc dopé n.

19. Procédé selon l'une quelconque des revendications précédentes, **caractérisé en ce que**
la première, la deuxième et la troisième étape de structuration conduisent ou contribuent à un montage monolithique intégré en série des cellules solaires et sont en particulier conçues par étapes de processus linéaires.

20. Procédé selon l'une quelconque des revendications précédentes, **caractérisé en ce que**
la formation des troisièmes rainures de séparation (24) se fait dans la troisième étape de structuration au moyen d'une structuration mécanique, en particulier d'une gravure à l'aiguille, et/ou au moyen d'un troisième traitement au laser.

21. Procédé selon la revendication 3,
**caractérisé en ce que**
le métal du chalcogénure métallique est sélectionné parmi le groupe se composant de molybdène, de tungstène, de tantale, de cobalt, de zirconium et/ou de niobium et/ou **en ce que** le chalcogène est sélectionné parmi le groupe se composant de sélénium et/ou de soufre.

22. Procédé selon l'une quelconque des revendications précédentes, **caractérisé en ce qu'**
au moins une première couche métallique composée de molybdène, de tantale, de tungstène, de cobalt, de zirconium et/ou de niobium est appliquée sur la couche barrière (6) et **en ce que** cette première couche métallique est transformée partiellement en une couche de chalcogénure métallique, lors de la fabrication de la couche absorbante semi-conductrice (10), en particulier de la couche absorbante semi-conductrice de kësterite ou de chalcopyrite, dans une atmosphère contenant du sélénium et/ou du soufre en formant la couche de contact (8).

23. Procédé selon l'une des revendications 1 à 22, **caractérisé en ce qu'**
au moins une première couche métallique composée de molybdène, de tantale, de tungstène, de cobalt, de zirconium et/ou de niobium est appliquée sur la couche barrière (6) et **en ce que** cette première couche métallique est transformée totalement en une couche de chalcogénure métallique, lors de la fabrication de la couche absorbante semi-conductrice (10), en particulier de la couche absorbante semi-conductrice de kësterite ou de chalcopyrite, dans une atmosphère contenant du sélénium et/ou du soufre en formant la couche de contact (8).

24. Procédé selon l'une quelconque des revendications précédentes, **caractérisé en ce que**
la couche barrière (6) présente une épaisseur moyenne d'au moins 10 nm, en particulier d'au moins 30 nm et de préférence au maximum de 250 nm ou de 150 nm, et/ou **en ce que** la couche de contact (8) présente une épaisseur moyenne d'au moins 5 nm et de préférence non supérieure à 150 nm, particulièrement préférée non supérieure à 50 nm.

25. Procédé selon l'une quelconque des revendications précédentes, **caractérisé en ce que**
les premières, deuxièmes et/ou troisièmes rainures de séparation (16, 20, 24) présentent une largeur moyenne non supérieure à 30 µm, de préférence non supérieure à 15 µm.

26. Procédé selon l'une quelconque des revendications précédentes, **caractérisé en ce que**
le substrat (2) représente une plaque de verre avec une largeur supérieure à 0,5 m, en particulier supérieure à 2,0 m, et une longueur supérieure à 1,2 m, en particulier supérieure à 3,0 m.

27. Procédé selon l'une quelconque des revendications précédentes, **caractérisé en ce que**
l'étape d'application de la couche absorbante semi-conductrice (10), en particulier de la couche absorbante semi-conductrice de kësterite ou de chalcopyrite, comprend : le dépôt sur la couche de contact (8), en particulier de la totalité, des composants métalliques de la couche absorbante semi-conductrice (10), en particulier du cuivre, de l'indium, et éventuellement du gallium pour la couche absorbante semi-conductrice de chalcopyrite et du cuivre, du zinc et de l'étain pour la couche absorbante semi-conductrice de kësterite, en formant une seconde couche métallique et le traitement de cette seconde couche métallique avec du sélénium et/ou un composé de sélénium ainsi qu'éventuellement avec du soufre et/ou un composé de soufre.

28. Procédé selon la revendication 27, **caractérisé en ce que**
le substrat (2) recouvert de couches est séparé, en particulier découpé, en plusieurs modules individuels avant le traitement de la seconde couche métallique, en particulier de la couche métallique de cuivre/indium, ou de la couche métallique de cuivre/indium/gallium ou de la couche métallique de cuivre/zinc/étain, avec du sélénium et/ou un composé de sélénium ainsi qu'éventuellement avec du soufre et/ou un composé de soufre.

29. Procédé selon la revendication 27 ou selon la revendication 28, **caractérisé en ce que** la première et/ou la seconde couche métallique sont obtenues au moyen d'un dépôt physique en phase vapeur, en particulier comprenant un revêtement par dépôt physique en phase vapeur (PVD-Physical Vapor Deposition), d'un dépôt physique en phase vapeur par faisceau d'électrons, d'un dépôt par évaporateur thermique, d'une évaporation par induction, d'une évaporation par ARC et/ou d'une pulvérisation cathodique (revêtement par pulvérisation), en particulier pulvérisation magnétron DC ou RF, respectivement de préférence sous vide poussé, ou par dépôt chimique en phase vapeur, comprenant en particulier le dépôt chimique en phase vapeur (CVD-Chemical Vapour Disposition), le CVD à basse pression (low pressure) et/ou le CVD à pression atmosphérique (atmospheric pressure).

30. Procédé selon l'une quelconque des revendications précédentes, **caractérisé en ce que**
l'application de la couche d'électrode arrière (4), de la couche barrière conductrice (6), de la couche de contact (8) et des métaux de la couche absorbante semi-conductrice (10), en particulier des couches Cu, In et Ga pour la formation de la couche absorbante semi-conductrice de chalcopyrite ou des couches Cu, Zn, et Sn pour la formation de la couche absorbante semi-conductrice de kësterite se fait dans une seule installation de revêtement sous vide, de préférence dans un procédé de pulvérisation cyclique.

31. Module solaire photovoltaïque à couche mince, fabriqué selon un procédé selon l'une quelconque des revendications précédentes, comprenant, dans cet ordre, une couche de substrat (2), une couche d'électrode arrière (4), une couche barrière conductrice (6), une couche de contact, en particulier ohmique, une couche absorbante semi-conductrice (10), en particulier une couche absorbante semi-conductrice de chalcopyrite ou de kësterite, en particulier située directement sur la couche de contact (8), éventuellement une couche tampon, en particulier une couche (première couche tampon (12)), contenant ou formée essentiellement de CdS ou d'une couche dépourvue de CdS, en particulier contenant ou formée essentiellement de Zn(S,OH) ou In₂S₃, et/ou éventuellement une couche (seconde couche tampon (14)), contenant et formée essentiellement d'oxyde de zinc intrinsèque et/ou d'oxyde de zinc avec résistance élevée,
et une couche d'électrode frontale (22),
dans lequel la couche barrière conductrice (6) représente une couche barrière à action bidirectionnelle pour des composants migrant hors de et/ou par la couche d'électrode arrière (4) et pour des composants migrant hors de et/ou par la couche de contact (8).

32. Module solaire à couche mince selon la revendication 31, **caractérisé en ce que** la couche absorbante semi-conductrice (10) représente ou comprend une couche de chalcopyrite IB-IIIA-VIA quaternaire, en particulier une couche de Cu(In,Ga)Se₂, une couche de chalcopyrite IB-IIIA-VIA quinternaire, en particulier une couche de Cu(In,Ga)(Se₁-ₓ,Sₓ)₂, ou une couche de kësterite, en particulier une couche de Cu₂ZnSn(Seₓ,S₁₋ₓ)₄, par exemple une couche Cu₂ZnSn(Se)₄ ou une couche Cu₂ZnSn(S)₄, x prenant des valeurs de 0 à 1.
